(19) Europäisches Patentamt
European Patent Office
Office européen des brevets

(11) **EP 4 415 263 A1**

(12) **EUROPEAN PATENT APPLICATION**

(43) Date of publication:
**14.08.2024 Bulletin 2024/33**

(21) Application number: **23155462.7**

(22) Date of filing: **07.02.2023**

(51) International Patent Classification (IPC):
*H03K 17/0814* (2006.01)     *H03K 17/691* (2006.01)

(52) Cooperative Patent Classification (CPC):
**H03K 17/08142; H03K 17/691**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Infineon Technologies Austria AG**
**9500 Villach (AT)**

(72) Inventors:
• **FRANK, Wolfgang**
  **86152 Augsburg (DE)**

• **KNIPPER, Richard**
  **93049 Regensburg (DE)**
• **KALT, Andreas**
  **9201 Krumpendorf am Wörthersee (AT)**
• **FABBRO, Simone**
  **33100 Udine (IT)**
• **GIACOMINI, Davide**
  **13855 VALDENGO (IT)**

(74) Representative: **Kraus & Lederer PartGmbB**
**Thomas-Wimmer-Ring 15**
**80539 München (DE)**

(54) **POWER SWITCH ASSEMBLY WITH CO-PACKAGED PROTECTION FUNCTION**

(57)     A power switch assembly comprises a power switch, a driving circuit configured to control the power switch, a protection device having a first current duration and a first current value and arranged between the driving circuit and the power switch, the protection device being configured to decouple the driving circuit from the power switch based on the first current duration and the first current value, and a clamping device having a second current duration and a second current value and arranged between the driving circuit, the protection device and the power switch, the clamping device being config-ured to couple the power switch to a second assembly load terminal of the power switch assembly based on the second current duration and the second current value. The first current duration is longer than the second cur-rent duration. The first current value is lower than the second current value.

Fig. 1

EP 4 415 263 A1

**Description**

TECHNICAL FIELD

The invention generally relates to protecting driving circuits against short circuits at a power switch and more precisely to the integration of such protection inside a power switch assembly.

BACKGROUND

During operation of a power switch, failure situations may occur during which a current may flow between a first load terminal of the power switch and a control terminal of the power switch. Such a current may lead to a high voltage at an output of a driving circuit coupled to the control terminal. The high voltage may then cause overheating and potentially destruction or even decapsulation of the driving circuit. The risk posed by the high current may be particularly pronounced for driving circuits with high internal resistances, such as gate drivers having a high internal resistance or solid state isolators.

In discrete systems, i.e. systems in which the power switch and the driving circuit are placed on a printed circuit board (PCB) and coupled to one another via traces on the PCB, various elements may be placed between the driving circuit and the power switch to protect the driving circuit against these currents. However, if the power switch and the driving circuit are arranged as a power switch assembly, i.e. if the power switch and the driving circuit are arranged in a single package, discrete protection solutions are not available.

Therefore, it is an objective of the present disclosure to protect driving circuits against currents caused by short circuits between terminals of a power switch in power switch assemblies.

SUMMARY OF THE INVENTION

To achieve this objective, the present disclosure provides a power switch assembly having an assembly control terminal, a first assembly load terminal and a second assembly load terminal, comprising a power switch having a control terminal, a first load terminal and a second load terminal, a driving circuit coupled to the control terminal and configured to control the power switch responsive to a control signal applied to the assembly control terminal, a protection device having a first current duration and a first current value and arranged between the driving circuit and the control terminal, the protection device being configured to decouple the driving circuit from the control terminal based on the first current duration and the first current value, a clamping device having a second current duration and a second current value and arranged between the driving circuit, the protection device and the second load terminal, the clamping device being configured to couple the control terminal to the second load terminal based on the second current duration and the second current value, wherein the first current duration is longer than the second current duration, and wherein the first current value is lower than the second current value.

The present disclosure further provides a protection method for a power switch assembly comprising a driving circuit, a protection device, a clamping device, a power switch having a control terminal, a first load terminal and a second load terminal, wherein the driving circuit is coupled to the control terminal via the protection device and the clamping device is arranged between the driving circuit, the protection device and the second load terminal, comprising operating the power switch based on a control signal provided to the driving circuit, while operating the power switch, decoupling the driving circuit from the control terminal based on a first current value and a first current duration of the protection device and, while operating the power switch, coupling the control terminal to the second load terminal based on a second current value and a second current duration of the clamping device, wherein the first current duration is longer than the second current duration, and wherein the first current value is lower than the second current value.

BRIEF DESCRIPTION OF THE DRAWINGS

Examples of the present disclosure will be described with reference to the following appended drawings, in which like reference signs refer to like elements.

FIG. 1 illustrates a power switch assembly according to examples of the present disclosure.

FIGS. 2A and 2B illustrate example driving circuits of the power switch assembly of Fig. 1 according to examples of the present disclosure.

FIG. 3 illustrates example clamping devices of the power switch assembly of Fig. 1 according to examples of the present disclosure.

FIGS. 4A and 4B illustrate example protection devices of the power switch assembly of Fig. 1 according to examples of the present disclosure.

FIG. 5 shows an exemplary current and associated events, which may trigger or not trigger the protection device of the power switch assembly of Fig. 1 according to examples of the present disclosure.

FIG. 6 provides a flowchart of a protection method for a power switch assembly according to examples of the present disclosure.

It should be understood that the above-identified drawings are in no way meant to limit the present disclosure. Rather, these drawings are provided to assist in understanding the present disclosure. The person skilled in the art will readily understand that aspects of the present invention shown in one drawing may be combined with aspects in another drawing or may be omitted without departing from the scope of the present disclosure.

DETAILED DESCRIPTION

The present disclosure generally provides a power switch assembly and corresponding protection method. The power switch assembly includes a power switch and a driving circuit coupled to a control terminal of the power switch. To protect the driving circuit against various short circuit events at the power switch, the power switch assembly further includes a protection device and a clamping device. The clamping device is configured to clamp, i.e. to couple, the control terminal to a second load terminal of the power switch. The protection device is configured to decouple the driving circuit from the control terminal. While both the clamping device and the protection device perform their respective protection functions based on a current present at the control terminal, they perform their respective functions only if different current values are exceeded for different current durations. This ensures that different current events at the control terminal trigger different protection responses based on the energy associated with the different current events.

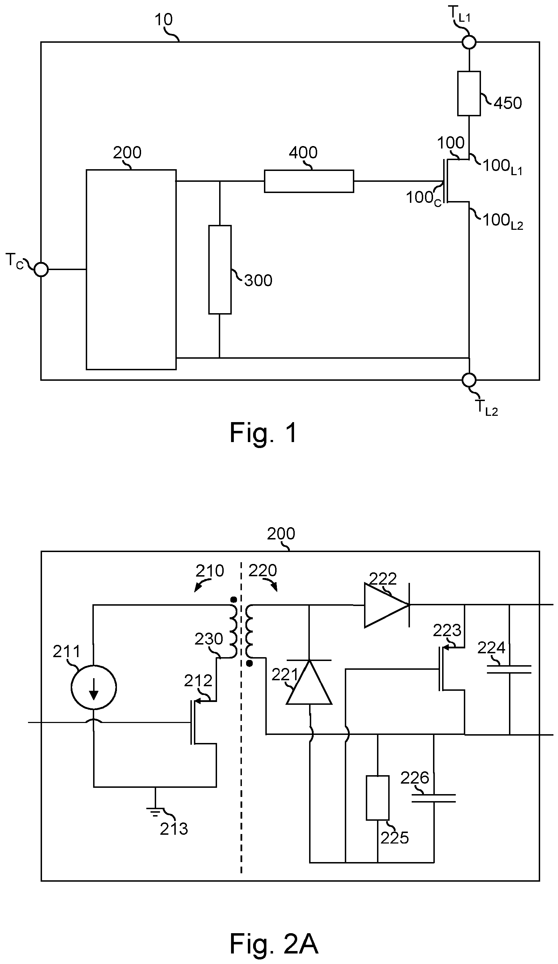

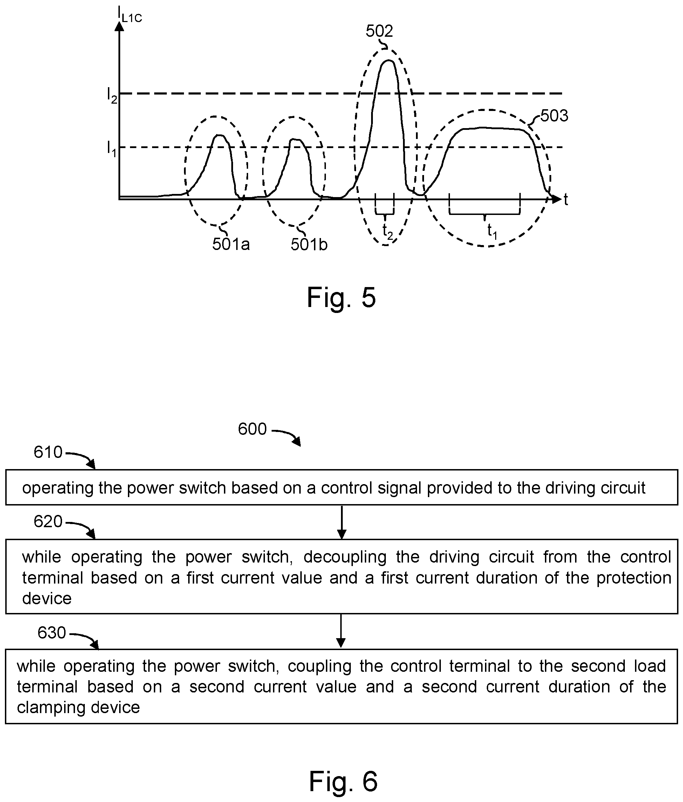

This general concept will be explained with reference to the appended drawings, with Fig. 1 providing an overview of the power switch assembly and Figs. 2A to 4B illustrating various exemplary aspects of the power switch assembly. In addition, Fig. 5 provides an illustration of the triggering of the respective protection functions. Finally, Fig. 6 illustrates the corresponding protection method.

FIG. 1 illustrates a power switch assembly 10. Power switch assembly 10 has an assembly control terminal $T_C$, a first assembly load terminal $T_{L1}$ and a second assembly load terminal $T_{L2}$.

Assembly control terminal $T_C$ may be configured to be coupled to an output of a control circuit, such as a microcontroller, and may accordingly be configured to receive a control signal indicating whether power switch assembly 10 should be switched into a conducting state or a nonconducting state. The control signal may for example be a pulse width modulation (PWM) signal, i.e. power switch assembly 10 may for example be controlled based on a duration of on-pulses of the control signal. The control signal may be an on-off keying (OOK) signal, i.e. power switch assembly 10 may for example be controlled based on the presence and the absence of a logic high value of the control signal. It will be understood that PWM signals and OOK signals are merely provided as an example control signal. Power switch assembly 10 may be controlled based on any type of control signal suitable for controlling power switches.

First assembly load terminal $T_{L1}$ may be configured to be coupled to a positive supply voltage DC+, which may for example provide a supply voltage of 450V, 600V, 1200V or 1800V. It will be understood that these voltage levels are merely provided as examples of a high voltage supply and may have any other voltage level depending on the application for which power switch assembly 10 is to be used. First assembly load terminal $T_{L1}$ may further be configured to be coupled to another power switch assembly 10, for example if two power switch assemblies 10 are used in a half-bridge configuration, or more generally to any type of power switch.

Second assembly load terminal $T_{L2}$ may be configured to be coupled to a negative supply voltage DC-, which may for example be 0V. It will be understood that the negative supply voltage DC- may also be at a voltage level above 0V or below 0V, depending on the application for which power switch assembly 10 is to be used. More generally, negative supply voltage DC- may be at any voltage level below the voltage level of positive supply voltage DC+. Second assembly load terminal $T_{L2}$ may further be configured to be coupled to another power switch assembly 10, for example if two power switch assemblies 10 are used in half-bridge configuration, or more generally to any type of power switch.

Assembly control terminal $T_C$, first assembly load terminal $T_{L1}$ and second assembly load terminal $T_{L2}$ may be part of, for example comprised in, a package of power switch assembly 10. The package may for example be formed using material typically used to form packages of integrated circuits, such as plastic materials like epoxy or ceramics. The package may consequently enclose all components of power switch assembly 10, which will be discussed in the following.

Power switch assembly 10 includes a power switch 100, a driving circuit 200, a clamping device 300 and a protection device 400. Power switch assembly 10 may further include a load path protection device 450.

Power switch 100 has a control terminal $100_C$, a first load terminal $100_{L1}$ and a second load terminal $100_{L2}$. Control terminal $100_C$ is coupled to driving circuit 200 via protection device 400. First load terminal $100_{L1}$ is coupled to first assembly load terminal $T_{L1}$, either directly or via load path protection device 450. Second load terminal $100_{L2}$ is coupled to second assembly load terminal $T_{L2}$. Accordingly, the expression "coupled" refers to both direct connections, as in the case of second load terminal $100_{L2}$, and connections with intervening elements, as in the case of control terminal $100_C$ and first load terminal $100_{L1}$.

Power switch 100 may be any kind of power switch configured to have a high voltage blocking capability. For example, power switch 100 may be able to block voltages above at least 400V, such as 450V, 900V, 1200V or 1800V. To achieve such voltage blocking capabilities, power switch 10 may for example be a silicon or silicon carbide (SiC) metal oxide field effect transistor (MOSFET), a silicon or SiC insulated gate bipolar transistor (IGBT) or a Gallium nitride high electron mobility transistor (GaN-HEMT). It will be understood that both the voltage levels and the technology types discussed with regard to power switch 10 are merely provided as an example. The present disclosure may be practiced with other high voltage levels and other power switch technologies than those mentioned here.

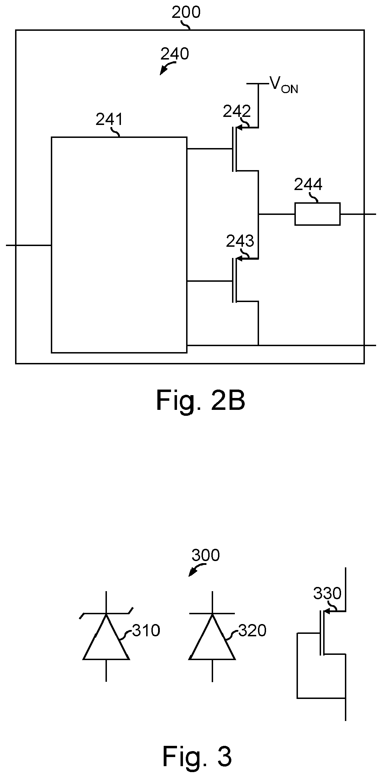

Driving circuit 200 is coupled to control terminal $100_C$ and configured to control power switch 100 responsive to the control signal applied to the assembly control terminal $T_C$ discussed above. In other words, driving circuit 200 is configured to switch power switch 100 on and off based on the control signal received by power switch assembly 100. To this end, driving circuit 200 may for example be implemented as shown in Figs. 2A and 2B.

As shown in Fig. 2A, driving circuit 200 may be a solid state isolator, which may be configured to generate one of a turn-on voltage and a turn-off voltage based on the control signal applied to the assembly control terminal.

Driving circuit 200 of Fig. 2A includes a galvanic isolation barrier 230, which in the example of Fig. 2A is shown as a transformer and may thus also be referred to as transformer 230. Transformer 230 divides driving circuit 200 into an input side 210, i.e. the circuitry coupled to the primary side of transformer 230, and an output side 220, i.e. the circuitry coupled to the secondary side of transformer 230. Transformer 230 may be formed based on any type of galvanic isolation, such as a coreless transformer.

Input side 210 may include an input voltage source 211, an input switch 212 and an input ground 213. A control terminal of input switch 212 may be coupled to assembly control terminal $T_C$ and may thus receive the control signal, which may for example be an OOK signal. While input switch 212 is controlled based on the control signal to be in a conductive state, a magnetization current may flow through the primary winding of transformer 230. The magnetization current flowing through the primary side of transformer 230 may cause magnetic energy to be stored in transformer 230 and may thereby cause a voltage drop at the secondary side of transformer 230. The voltage drop at the primary side may be inverted with respect to the voltage drop at the primary side of transformer 230 caused by input voltage source 211. Once input switch 212 is controlled based on the control signal to no longer be in the conductive state, the magnetic energy stored in transformer 230 may be discharged at the secondary side of transformer 230.

Output side 220 may include a first diode 221, a second diode 222, a turn-off switch 223, a turn-on capacitor 224, resistor 225 and a turn-off capacitor 226. First diode 221, resistor 225 and a turn-off capacitor 226 may also collectively be referred to as a negative charge pump. The two output terminals of output side 220 may respectively be coupled to control terminal $100_C$ and second assembly load terminal $T_{L2}$.

While input switch 212 is controlled to cause transformer 230 to provide the inverse voltage drop at the secondary side, turn-off capacitor 226 may be charged. The energy charged in turn-off capacitor 226 may be used to charge a control terminal of turn-off switch 223, causing turn-off switch 223 to be conductive. While turn-off switch 223 is caused to be conductive, control terminal $100_C$ and second assembly load terminal $T_{L2}$ may be coupled, keeping power switch 100 in a non-conductive state. Further, since the inverse voltage at the secondary side of transformer 230 causes a potential at the anode of second diode 222 to be below the potential at the cathode of second diode 222, second diode 222 blocks current from flowing toward control terminal $100_C$.

Once input switch 212 is controlled to no longer be in the conductive state, the voltage at the secondary side of transformer 230 is no longer inverted. Accordingly, second diode 222 may no longer block current from flowing toward control terminal $100_C$. This may allow the energy stored in transformer 230 to be discharged towards control terminal $100_C$, causing energy to be stored in turn-on capacitor 224. The energy stored in turn-on capacitor 224 may in turn charge control terminal $100_C$, causing power switch 100 to be in a conductive state. In addition, turn-off capacitor 226 may be discharged during the discharging of the energy stored in transformer 230, causing the control terminal of turn-off switch 223 to likewise be discharged and thereby causing turn-off switch 223 to be non-conductive. Accordingly, turn-off switch 223 may no longer couple control terminal $100_C$ to second assembly load terminal $T_{L2}$, thereby enabling charging control terminal $100_C$.

As can be seen from the discussion of Fig. 2A, driving circuit 200 in the example of Fig. 2 is coupled to control terminal $100_C$ via the output side 230, which may have an internal resistance of several kΩ, for example 100 kΩ. Accordingly, driving circuit 200 of Fig. 2A may be considered as having a high internal resistance.

As shown in Fig. 2B, driving circuit 200 may be a gate driver, which may be configured to selectively couple the control terminal to one of a turn-on voltage source and a turn-off voltage source.

Driving circuit 200 of Fig. 2B may be gate driver 240, which may include a control logic 241, a turn-on transistor 242, a turn-off transistor 243 and an internal on-resistance 244. It will be understood that gate driver 240 may include further components, in particular an isolation region, for example if power switch assembly 10 is to be used as a high-side switch in a half-bridge configuration. Such an isolation region may for example be arranged between control logic 241 and turn-on transistor 242 as well as turn-off transistor 243.

Control logic 241 may be any kind of control logic, such as a microcontroller, which is configured to receive the control signal and control power switch 100 accordingly. To this end, control logic 241 may be configured to be coupled to assembly control terminal $T_C$ in order to receive the control signal, which may for example be a PWM signal. If the control signal indicates that power switch assembly 10 should be switched into the conductive state, control logic 241 may cause turn-on transistor 242 to be conductive, thereby coupling turn-on voltage $V_{ON}$ to control terminal $100_C$ via internal on-resistance 244. Analogously, if the control signal indicates that power switch assembly 10 should be switched into the nonconductive state, control logic 241 may cause turn-off transistor 243 to be conductive, thereby coupling control terminal $100_C$ to second assembly load terminal $T_{L2}$ and second load terminal $100_{L2}$.

The internal on-resistance 244 may in some examples have a value of several k$\Omega$, for example 100 k$\Omega$. Accordingly, gate driver 240 may be considered as having a high internal resistance. It will be understood that internal on-resistance 244 is merely shown as an individual component in Fig. 2B in order to illustrate the fact that gate driver 240 may have a high internal resistance. In example implementations of gate driver 240, the high internal resistance may be provided by turn-on transistor 242 and turn-off transistor 243. In other words, internal on-resistance 244 may not be present as an individual component.

While driving circuit 200 of both Figs. 2A and 2B is described as having a high internal resistance, it will be understood that the present disclosure is not limited to such driving circuits and may also be practiced with driving circuits having low internal resistances.

Protection device 400 is arranged between driving circuit 200 and control terminal $100_C$ and has a first current duration and a first current value. Based on the first current duration and the first current value, protection device 400 is configured to decouple driving circuit 200 from control terminal $100_C$. In other words, protection device 400 is configured to decouple driving circuit 200 from control terminal $100_C$ based on a first energy absorbed by or dissipated in protection device 400.

Generally speaking, electric energy absorbed by a device, i.e. for example stored, may be expressed as

$$ E = U * Q \qquad (1) $$

with E denoting energy, U denoting a voltage across the device and Q denoting a charge absorbed by the device in equation (1). Charge Q absorbed by the device may be expressed as

$$ Q = I * t \qquad (2) $$

with I denoting the current flowing through the device and t denoting the duration for which the current flows through the device. Substituting charge Q in equation (1) with equation (2) leads to the following modified equation for the absorbed energy:

$$ E = U * I * t \qquad (3) $$

Finally, substituting voltage U based on Ohm's law modifies equation (3) as follows:

$$ E = R * I^2 * t \qquad (4) $$

In equation (4), R denotes an internal resistance of the device. Accordingly, the first energy based on which protection device 400 is configured to decouple driving circuit 200 from control terminal $100_C$ may be expressed based on equation (4) as follows:

$$ E_1 = R * I_1^2 * t_1 \qquad (5) $$

In equation (5), $E_1$ denotes the first energy absorbed by protection device 400, R denotes an internal resistance of protection device 400, $I_1$ denotes the first current value and $t_1$ denotes the first current duration. The internal resistance of protection device 400 depends on the implementation of protection device 400 and the technology used to implement protection device 400. The first current value and the first current level define the type of fault condition against which protection device 400 is configured to protect by decoupling driving circuit 200 from control terminal $100_C$. Accordingly, the fault condition is determined by how long a current indicative of the fault condition and at what current level the current indicative of the fault condition is to flow.

The current may be a current flowing between first load terminal $100_{L1}$ and control terminal $100_C$. In other words, the current may be a current flowing if an isolation barrier between control terminal $100_C$ and first load terminal $100_{L1}$ fails. This current may lead to a high voltage at the output of the driving circuit if protection device 400 is not present, in particular if driving circuit 200 is implemented with a high internal resistance, such as internal on-resistance 244. In other words, by decoupling driving circuit 200 from control terminal $100_C$ based on the first current value and the first current duration, protection device 400 is configured to protect driving circuit 200 from a short circuit between control terminal $100_C$ and first load terminal $100_{L1}$ and to prevent a propagation of the high current along the signal path of the control signal.

Clamping device 300 is arranged between driving circuit 200, protection device 400 and second load terminal $100_{L2}$. Clamping device 300 has a second current duration and a second current value. Based on the second current duration and the second current value, clamping device 300 is configured to couple control terminal $100_C$ to second load terminal $100_{L2}$. In other words, clamping device 300 may be configured to couple control terminal $100_C$ to second load terminal $100_{L2}$ based on clamping device 300 absorbing a second energy. Analogously to the first energy, the second energy may be expressed as follows:

$$E_2 = R * I_2{}^2 * t_2 \quad (6)$$

In equation (6), $E_2$ denotes the second energy absorbed by clamping device 300, R denotes an internal resistance of clamping device 300, $I_2$ denotes the second current value and $t_2$ denotes the second current duration. The internal resistance of the clamping device depends on the implementation of clamping device 300 and the technology used to implement clamping device 300. The second current value and the second current level define the type of fault condition against which clamping device 300 is configured to protect by coupling control terminal $100_C$ to second load terminal $100_{L2}$.

As discussed above with regard to protection device 400, the fault condition in the case of protection device 300 is likewise determined by how long a current indicative of the fault condition and at what current level the current indicative of the fault condition is to flow. In the case of protection device 300, the fault condition may for example be an electrostatic discharge (ESD) event. More generally, the fault conditions against which protection device 400 and clamping device 300 protect differ. Accordingly, the first current duration is longer than the second current duration and the first current value is lower than the second current value. In other words, protection device 400 is configured to protect against short circuits characterized by a comparatively lower current occurring over longer periods of time while clamping device 300 is configured to protect against short circuits characterized by a comparatively higher current occurring over shorter periods of time.

In some examples of the present disclosure, the first current duration may be in the range of milliseconds while the second current duration may in the range of microseconds. Correspondingly, the first current value may be a value up to 100 mA while the second current value may at least be 500 mA. It will be understood that these numeric examples are merely provided as an example to help in understanding the difference between the first current duration and the second current duration as well as between the first current value and the second current value.

Examples of short circuit or triggering events not triggering or triggering, respectively, the protection of one of clamping device 300 and protection device 400 is shown in Fig. 5. Fig. 5 illustrates a current $I_{L1C}$ flowing from first load terminal $100_{L1}$ to control terminal $100_C$ and through protection device 400 and clamping device 300 over time. Current $I_{L1C}$ includes two non-triggering events 501a and 501b as well as two triggering events 502 and 503.

Non-triggering events 501a and 501b exceed first current value $I_1$ but not for the first current duration $t_1$. Further, Non-triggering events 501a and 501b exceed second current duration $t_2$ but do not exceed second current value I2.

Triggering event 502 exceeds both second current value $I_2$ and second current duration $t_2$, thus triggering protection device 300. Triggering event 503 exceeds both first current value $I_1$ and first current duration $t_1$, thus triggering protection device 400. In other words, protection device 400 may be configured to decouple driving circuit 200 from control terminal $100_C$ if the current flowing through protection device 400 exceeds first current value $I_1$ for the entire first current duration $t_1$. Likewise, clamping device 300 may be configured to couple control terminal $100_C$ to second load terminal $100_{L2}$ if the current flowing through protection device 300 exceeds second current value $I_2$ for the entire second current duration $t_2$.

It will be understood that the timeline in Fig. 5 is provided merely as an example. During operation of power switch assembly 10, many non-triggering events may occur, with long operating durations therebetween without any non-triggering events. Likewise, depending on the implementation of clamping device 300 and protection device 400, at least events triggering clamping device 300 may occur more than once at various times during operation of power switch assembly 10.

In summary, protection device 400 is configured to be triggered once protection device 400 has absorbed the first energy while clamping device 300 is configured to be triggered once clamping device has absorbed the second energy. The first energy is characterized by the first current value and the first current value while the second energy is characterized by the second current value and the second current value. Given that the first current value is lower than the second current value and that the first current duration is longer than the second current duration, clamping device 300 and protection device 400 are configured to protect against different types of short circuits. Clamping device 300 is configured to protect against short circuits characterized by a high current for a short time while protection device 400 is configured to protect against short circuits characterized by a lower current for a longer time.

It will be understood that clamping device 300 and protection device 400 are not triggered if the first energy and the second energy are respectively absorbed by clamping device 300 and protection device 400 outside the time frame specified by the first current duration and the second duration. Evidently, given that power switch assembly 10 may be configured to operate for thousands of operating hours, clamping device 300 and protection device 400, both devices may absorb energies exceeding the first energy and the second energy. However, since such energies may be absorbed over many operating hours rather than during the comparatively short timeframes defined by the first current duration and the second current duration, such absorbed energies do not trigger clamping device 300 and protection device 400.

To prevent clamping device 300 from being triggered based on the first energy, clamping device 300 may be configured to keep control terminal $100_C$ and second load terminal $100_{L2}$ decoupled if the current flowing through protection device 400 exceeds the first current value for the entire first current duration. This ensures that clamping device 300 is only triggered in the case of a short circuit against which clamping device 300 is configured to protect against and not in the case of a short circuit against which protection device 400 is configured to protect.

Given that clamping device 300 and protection device 400 are configured to protect against different types of short circuits with different associated energies, their protection mechanism may also be not permanent and permanent, respectively. That is, protection device 400 may be configured to irreversibly decouple driving circuit 200 from control terminal $100_C$, while clamping device 300 may be configured to reversibly couple control terminal $100_C$ to second load terminal $100_{L2}$. In other words, protection device 400 may at least partially disintegrate a section of the connection between driving circuit 200 and control terminal $100_C$ while clamping device 300 may decouple control terminal $100_C$ from second load terminal $100_{L2}$ once the second energy has dissipated.

Based on the above discussed general concept of clamping device 300 and protection device 400, exemplary implementations of clamping device 300 and protection device 400 in accordance with this general concept will be discussed in the following with reference to Figs. 3 to 4B.

Fig. 3 illustrates three exemplary implementations of clamping device 300, i.e. a Zener diode 310, a pn-junction 320 and a grounded n-metal oxide semiconductor (nMOS) transistor 330.

In the example of clamping device 300 being implemented by Zener diode 310, a cathode of Zener diode 310 is coupled to second load terminal $100_{L2}$. Based on this orientation of Zener diode 310, clamping device 300 may be configured to controllably couple control terminal $100_C$ to second load terminal $100_{L2}$ based on a Zener voltage of Zener diode 310. In other words, Zener diode 310 may be configured to have a Zener voltage which is present if the second current value is exceeded for the second current duration.

In the example of clamping device 300 being implemented by pn-junction 320, a cathode of pn-junction 320 is coupled to second load terminal $100_{L2}$. Based on this orientation of pn-junction 320, clamping device 300 may be configured to couple control terminal $100_C$ to second load terminal $100_{L2}$ based on a breakdown voltage pn-junction 320. In other words, pn-junction 320 may be configured to have a breakdown voltage which is present if the second current value is exceeded for the second current duration.

In the example of clamping device 300 being implemented by n-MOS transistor 330, a gate of n-MOS transistor 330 is coupled to second load terminal $100_{L2}$. Based on this arrangement of n-MOS transistor 330, clamping device 300 may be configured to controllably couple control terminal $100_C$ to second load terminal $100_{L2}$ based on the voltage at second load terminal $100_{L2}$.

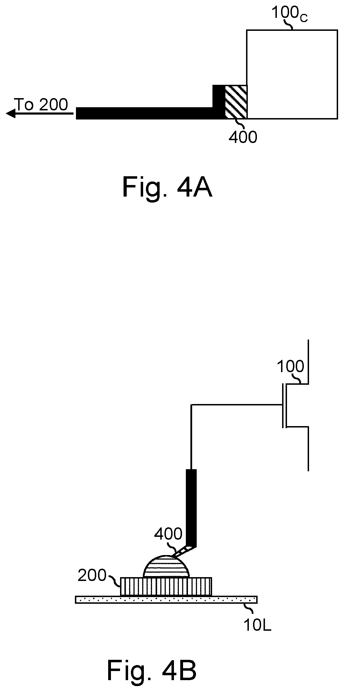

Figs. 4A and 4B illustrate two exemplary implementations of protection device 400.

Fig. 4A shows a simplified top view of an implementation of power switch assembly 10, in which power switch 100, driving circuit 200, protection device 400 and clamping device 300 may be formed on a single multilayered substrate (not shown in Fig. 4A). In the example implementation of Fig. 4A, protection device 400 may be formed on a metal layer of the multi-layered substrate as a connection between driving circuit 200 and control terminal $100_C$. As illustrated in Fig. 4A, control terminal $100_C$ may be a control pad. Protection device 400 may be arranged between control pad $100_C$ and a metal trace continuing toward driving circuit 200, as indicated by the arrow in Fig. 4A. It will be understood that protection device 400 may also be arranged between two metal traces, one coming from control pad $100_C$ and the other one continuing toward driving circuit 200. Based on this arrangement, protection device 400 may provide a connection between control pad $100_C$ and the metal trace. In order to provide the protection function of protection device 400 discussed above, this connection may be configured to disintegrate based on the first current duration and the first current value. In other words, the connection may be configured to disintegrate if it has absorbed the first energy in the timeframe defined by the first current duration.

Fig. 4B shows a simplified side view of a section of power switch assembly 10. The simplified side view shows a lead frame 10L, on which driving circuit 200 is arranged. On top of driving circuit 200, dome-shaped conductive material is placed, which may for example be solder. The dome shaped conductive material may be coupled to a connection, such as a bond wire or a metal clip, which continues onward to control terminal $100_C$ of power switch 100. Protection device 400 may be integrated into the connection to provide a disintegration location. The disintegration location may be configured to disintegrate based on the first current duration and the first current value in order to decouple driving circuit 200 and control terminal $100_C$. To this end, protection device 400 may be made of a material which disintegrates if it absorbs the second energy during the timeframe defined by the first current duration.

Load path protection device 450 may be configured to decouple first assembly load terminal $T_{L1}$ from first load terminal $100_{L1}$ based on the first current duration and the first current value. That is, load path protection device 450 may provide the same protection function as protection device 400 based on the same energy. In other words, load path protection device 450 may provide, if present in power switch assembly 10, an additional protection in the load path in addition to the protection provided by protection device 400 in the control path against a high current flowing into power switch assembly 10 via first assembly load terminal $T_{L1}$. Load path protection device 450 may thus be implemented similarly to protection device 400.

Fig. 6 provides a flowchart of a protection method 600, which may protect power switch assembly 10 based on the principles discussed above. It will be understood that the order of the steps of method 600 shown in Fig. 6 is merely provided as an example. The steps may be performed in any order, may be performed concurrently, or one step may be performed a plurality of times without necessarily also performing the other step, depending on the respective implementation of method 600.

In step 610, method 600 operates power switch 100 based on the control signal provided to driving circuit 200.

In step 620, method 600 decouples driving circuit 200 from control terminal $100_C$ using protection device 400 based on the first current value and the first current duration of protection device 400 while operating power switch 100.

In step 630, method 600 couples control terminal $100_C$ to second load terminal $100_{L2}$ based on the second current value and the second current duration using clamping device 300 while operating power switch 100.

The invention may further be illustrated by the following examples.

In an example, a power switch assembly having an assembly control terminal, a first assembly load terminal and a second assembly load terminal, comprises a power switch having a control terminal, a first load terminal and a second load terminal, a driving circuit coupled to the control terminal and configured to control the power switch responsive to a control signal applied to the assembly control terminal, a protection device having a first current duration and a first current value and arranged between the driving circuit and the control terminal, the protection device being configured to decouple the driving circuit from the control terminal based on the first current duration and the first current value, a clamping device having a second current duration and a second current value and arranged between the driving circuit, the protection device and the second load terminal, the clamping device being configured to couple the control terminal to the second load terminal based on the second current duration and the second current value, wherein the first current duration is longer than the second current duration, and wherein the first current value is lower than the second current value.

In an example, the protection device may be configured to decouple the driving circuit from the control terminal if a current flowing through the protection device exceeds the first current value for the entire first current duration, and the clamping device may be configured to couple the control terminal to the second load terminal if a current flowing through the protection device exceeds the second current value for the entire second current duration.

In an example, the clamping device may be configured to keep the control terminal and the second load terminal decoupled if the current flowing through the protection device exceeds the first current value for the entire first current duration.

In an example, the current may be a current flowing between the first load terminal and the control terminal.

In an example, the protection device may be configured to irreversibly decouple the driving circuit from the control terminal, and the clamping device may be configured to reversibly couple the control terminal to the second load terminal.

In an example, the power switch, the driving circuit, the protection device and the clamping device may be formed on a single multi-layered substrate, and the protection device may be formed on a metal layer of the multi-layered substrate as a connection between the driving circuit and the control terminal, wherein the connection may be configured to disintegrate based on the first current duration and the first current value.

In an example, the protection device may be integrated into a connection between the driving circuit and the control terminal to provide a disintegration location, the disintegration location being configured to disintegrate based on the first current duration and the first current value.

In an example, the power switch assembly may further comprise a load path protection device, the load path protection device being configured to decouple the first assembly load terminal from the first load terminal based on the first current duration and the first current value.

In an example, the clamping device may be configured to protect the driving circuit against an ESD event.

In an example, the clamping device may be one of an n-MOS transistor, wherein a gate of the n-MOS transistor may be coupled to the second load terminal, a Zener diode, wherein a cathode of the Zener diode may be coupled to the second load terminal or a pn-junction, wherein a cathode of the pn-junction may be coupled to the second load terminal.

In an example, the driving circuit may be a solid state isolator, configured to generate one of a turn-on voltage and a turn-off voltage based on the control signal applied to the assembly control terminal.

In an example, the driving circuit may be a gate driver, the gate driver being configured to selectively couple the control terminal to one of a turn-on voltage source and a turn-off voltage source.

In an example, a protection method for a power switch assembly comprising a driving circuit, a protection device, a clamping device, a power switch having a control terminal, a first load terminal and a second load terminal, wherein the driving circuit is coupled to the control terminal via the protection device and the clamping device is arranged between the driving circuit, the protection device and the second load terminal, comprises operating the power switch based on a control signal provided to the driving circuit, while operating the power switch, decoupling the driving circuit from the control terminal based on a first current value and a first current duration of the protection device, and while operating the power switch, coupling the control terminal to the second load terminal based on a second current value and a second current duration of the clamping device, wherein the first current duration is longer than the second current duration, and wherein the first current value is lower than the second current value.

The preceding description has been provided to illustrate a power switch assembly with a co-packaged protection function. It should be understood that the description is in no way meant to limit the scope of the present disclosure to the precise embodiments discussed throughout the description. Rather, the person skilled in the art will be aware that the examples of the present disclosure may be combined, modified or condensed without departing from the scope of the present disclosure as defined by the following claims.

**Claims**

1. A power switch assembly (10) having an assembly control terminal ($T_C$), a first assembly load terminal ($T_{L1}$) and a second assembly load terminal ($T_{L2}$), comprising:

   a power switch (100) having a control terminal ($100_C$), a first load terminal ($100_{L1}$) and a second load terminal ($100_{L2}$);
   a driving circuit (200) coupled to the control terminal ($100_c$) and configured to control the power switch (100) responsive to a control signal applied to the assembly control terminal ($T_C$);
   a protection device (400) having a first current duration ($t_1$) and a first current value ($I_1$) and arranged between the driving circuit (200) and the control terminal ($100_C$), the protection device (400) being configured to decouple the driving circuit (200) from the control terminal ($100_C$) based on the first current duration ($t_1$) and the first current value ($I_1$); and
   a clamping device (300) having a second current duration ($t_2$) and a second current value ($I_2$) and arranged between the driving circuit (200), the protection device (400) and the second load terminal ($100_{L2}$), the clamping device (300) being configured to couple the control terminal ($100_C$) to the second load terminal ($100_{L2}$) based on the second current duration ($t_2$) and the second current value ($I_2$),
   wherein the first current duration ($t_1$) is longer than the second current duration ($t_2$), and
   wherein the first current value ($I_1$) is lower than the second current value ($I_2$).

2. The power switch assembly (10) of claim 1, wherein:

   the protection device (400) is configured to decouple the driving circuit (200) from the control terminal ($100_C$) if a current flowing through the protection device (400) exceeds the first current value ($I_1$) for the entire first current duration ($t_1$), and
   the clamping device (300) is configured to couple the control terminal ($100_C$) to the second load terminal ($100_{L2}$) if a current flowing through the protection device (400) exceeds the second current value ($I_2$) for the entire second current duration ($t_2$).

3. The power switch assembly (10) of claim 2, wherein the clamping device (300) is configured to keep the control terminal ($100_C$) and the second load terminal ($100_{L2}$) decoupled if the current flowing through the protection device (400) exceeds the first current value ($I_1$) for the entire first current duration ($t_2$).

4. The power switch assembly (10) of any one of claims 2 and 3, wherein the current is a current flowing between the first load terminal ($100_{L1}$) and the control terminal ($100_C$).

5. The power switch assembly (10) of any one of the preceding claims, wherein:

   the protection device (400) is configured to irreversibly decouple the driving circuit (200) from the control terminal ($100_C$), and
   the clamping device (300) is configured to reversibly couple the control terminal ($100_C$) to the second load terminal ($100_{L2}$).

6. The power switch assembly (10) of any one of the preceding claims, wherein:

   the power switch (100), the driving circuit (200), the protection device (400) and the clamping device (300) are formed on a single multi-layered substrate; and
   the protection device (400) is formed on a metal layer of the multi-layered substrate as a connection between the driving circuit (200) and the control terminal ($100_C$), wherein the connection is configured to disintegrate based on the first current duration ($t_1$) and the first current value ($I_1$).

7. The power switch assembly (10) of any one of claims 1 to 5, wherein the protection device (400) is integrated into a connection between the driving circuit (200) and the control terminal ($100_C$) to provide a disintegration location, the disintegration location being configured to disintegrate based on the first

current duration ($t_1$) and the first current value ($I_1$).

8. The power switch assembly (10) of any one of the preceding claims, wherein the power switch assembly (10) further comprises a load path protection device (450), the load path protection device (450) being configured to decouple the first assembly load terminal ($T_{L1}$) from the first load terminal ($100_{L1}$) based on the first current duration ($t_1$) and the first current value ($I_1$).

9. The power switch assembly (10) of any one of the preceding claims, wherein the clamping device (300) is configured to protect the driving circuit (200) against an electrostatic discharge -ESD- event.

10. The power switch (10) assembly of any one of the preceding claims, wherein the clamping device (300) is one of:

an n-metal oxide semiconductor -n-MOS- transistor (330), wherein a gate of the n-MOS transistor is coupled to the second load terminal ($100_{L2}$);
a Zener diode (310), wherein a cathode of the Zener diode (310) is coupled to the second load terminal ($100_{L2}$); or
a pn-junction (320), wherein a cathode of the pn-junction (320) is coupled to the second load terminal ($100_{L2}$).

11. The power switch assembly (10) of any one of the preceding claims, wherein the driving circuit (200) is a solid state isolator, the solid state isolator being configured to generate one of a turn-on voltage and a turn-off voltage based on the control signal applied to the assembly control terminal ($T_C$).

12. The power switch assembly (10) of any one of the claims 1 to 11, wherein the driving circuit (200) is a gate driver (240), the gate driver (240) being configured to selectively couple the control terminal ($100_C$) to one of a turn-on voltage source and a turn-off voltage source.

13. A protection method (600) for a power switch assembly (10) comprising a driving circuit (200), a protection device (400), a clamping device (300), and a power switch (100) having a control terminal ($100_C$), a first load terminal ($100_{L1}$) and a second load terminal ($100_{L2}$), wherein the driving circuit (200) is coupled to the control terminal ($100_C$) via the protection device (400) and the clamping device (300) is arranged between the driving circuit (200), the protection device (400) and the second load terminal ($100_{L2}$), comprising:

operating (610) the power switch (100) based on a control signal provided to the driving circuit (200);
while operating the power switch (100), decoupling (620) the driving circuit (200) from the control terminal ($100_C$) based on a first current value ($I_1$) and a first current duration ($t_1$) of the protection device (400); and
while operating the power switch, coupling (630) the control terminal ($100_C$) to the second load terminal ($100_{L2}$) based on a second current value ($I_2$) and a second current duration ($t_2$) of the clamping device (300),
wherein the first current duration ($t_1$) is longer than the second current duration ($t_2$), and
wherein the first current value ($I_1$) is lower than the second current value ($I_2$).

Fig. 1

Fig. 2A

200

240

241

242

V_ON

244

243

Fig. 2B

300

310

320

330

Fig. 3

100<sub>c</sub>

To 200

400

Fig. 4A

100

400

200

10L

Fig. 4B

Fig. 5

600

610

operating the power switch based on a control signal provided to the driving circuit

620

while operating the power switch, decoupling the driving circuit from the control terminal based on a first current value and a first current duration of the protection device

630

while operating the power switch, coupling the control terminal to the second load terminal based on a second current value and a second current duration of the clamping device

Fig. 6

EP 4 415 263 A1

## EUROPEAN SEARCH REPORT

**Application Number**

EP 23 15 5462

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/205220 A1 (ELLIOTT DAVID ALAN [GB]) 19 July 2018 (2018-07-19) <br> * paragraph [0030] – paragraph [0034]; figure 3 * <br> * paragraph [0039] – paragraph [0040] * | 1–13 | INV. <br> H03K17/0814 <br> H03K17/691 |
| X <br> A | US 2014/028358 A1 (CHIMENTO FILIPPO [SE] ET AL) 30 January 2014 (2014-01-30) <br> * paragraph [0043] – paragraph [0045]; figure 2a * | 1–3,5, 10,12,13 <br> 4,6–9,11 | |
| X <br> A | JP S52 123160 A (MITSUBISHI ELECTRIC CORP) 17 October 1977 (1977-10-17) <br> * page 312; figures 3,5 * | 1–3,5, 10,12,13 <br> 4,6–9,11 | |
| A | CN 108 736 869 A (SHENZHEN FAITHTECH CO LTD) 2 November 2018 (2018-11-02) <br> * figures 1,2 * | 1–13 | |
| | | | **TECHNICAL FIELDS SEARCHED (IPC)** <br><br> H03K |

The present search report has been drawn up for all claims

| Place of search | Date of completion of the search | Examiner |
|---|---|---|
| The Hague | 6 July 2023 | O'Reilly, Siobhan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 15 5462

This annex lists the patent family members relating to the patent documents cited in the above-mentioned European search report.
The members are as contained in the European Patent Office EDP file on
The European Patent Office is in no way liable for these particulars which are merely given for the purpose of information.

06-07-2023

| Patent document cited in search report | | Publication date | Patent family member(s) | | Publication date |
|---|---|---|---|---|---|
| US 2018205220 | A1 | 19-07-2018 | CN | 108321764 A | 24-07-2018 |
| | | | CN | 114024292 A | 08-02-2022 |
| | | | GB | 2558655 A | 18-07-2018 |
| | | | US | 2018205220 A1 | 19-07-2018 |
| US 2014028358 | A1 | 30-01-2014 | AU | 2011362347 A1 | 15-08-2013 |
| | | | CA | 2830330 A1 | 20-09-2012 |
| | | | CN | 103430437 A | 04-12-2013 |
| | | | EP | 2686943 A1 | 22-01-2014 |
| | | | US | 2014028358 A1 | 30-01-2014 |
| | | | WO | 2012123027 A1 | 20-09-2012 |
| JP S52123160 | A | 17-10-1977 | JP | S5834054 B2 | 23-07-1983 |
| | | | JP | S52123160 A | 17-10-1977 |
| CN 108736869 | A | 02-11-2018 | NONE | | |

EPO FORM P0459

For more details about this annex : see Official Journal of the European Patent Office, No. 12/82